(19) Europäisches Patentamt

European Patent Office

Office européen des brevets

(11) **EP 0 903 862 B1**

(12) **EUROPEAN PATENT SPECIFICATION**

(45) Date of publication and mention
of the grant of the patent:
**25.06.2003 Bulletin 2003/26**

(51) Int Cl.[7]: **H03M 3/00**, H03H 19/00

(21) Application number: **97830458.2**

(22) Date of filing: **19.09.1997**

(54) **Double sampled switched capacitor low pass multirate filter of a sigma delta D/A converter**

Tiefpassfilter mit mehreren Übertragungsraten mit geschalteten Kondensatoren und doppelter Signalabtastung für sigma-delta Digital-/Analog-Wandler

Filtre passe-bas multidébit à capacités commutées à double échantillonnage d'un convertisseur numérique analogique du type sigma delta

(84) Designated Contracting States:
**DE FR GB IT**

(43) Date of publication of application:
**24.03.1999 Bulletin 1999/12**

(73) Proprietor: **STMicroelectronics S.r.l.**
**20041 Agrate Brianza (Milano) (IT)**

(72) Inventors:
• **Nagari, Angelo**
**27024 Cilavegna (IT)**
• **Nicollini, Germano**
**29100 Piacenza (IT)**

(74) Representative: **Pellegri, Alberto et al**
**c/o Società Italiana Brevetti S.p.A.**
**Piazza Repubblica, 5**
**21100 Varese (IT)**

(56) References cited:
**WO-A-94/23494**

• **LE TOUMELIN L ET AL: "A 5-V CMOS LINE CONTROLLER WITH 16-BIT AUDIO CONVERTERS" PROCEEDINGS OF THE CUSTOM INTEGRATED CIRCUITS CONFERENCE, SAN DIEGO, MAY 12 - 15, 1991, no. CONF. 13, 12 May 1991, INSTITUTE OF ELECTRICAL AND ELECTRONICS ENGINEERS, pages 24.5.1-24.5.5, XP000295796**
• **CHUNG-YU WU ET AL: "DESIGN TECHNIQUES FOR HIGH-FREQUENCY CMOS SWITCHED-CAPACITOR FILTERS USING NON-OP-AMP-BASED UNITY-GAIN AMPLIFIERS" IEEE JOURNAL OF SOLID-STATE CIRCUITS, vol. 26, no. 10, 1 October 1991, pages 1460-1466, XP000264313**

## Description

### FIELD OF THE INVENTION

The invention relates in general to a sigma-delta ($\Sigma\Delta$) digital-analog (D/A) converter and more in particular to the analog part of the converting system that substantially comprises a low pass filter for reconstructing of the analog signal from the digital output stream of the $\Sigma\Delta$ demodulator.

### BACKGROUND OF THE INVENTION

A $\Sigma\Delta$ digital-analog converter, must be necessarily followed by a low pass filter in order to reconstruct the signal from the output bitstream of the $\Sigma\Delta$ demodulator of the D/A converter. There are many solutions that combine switched-capacitors techniques (SC) with continuous-time (CT) techniques.

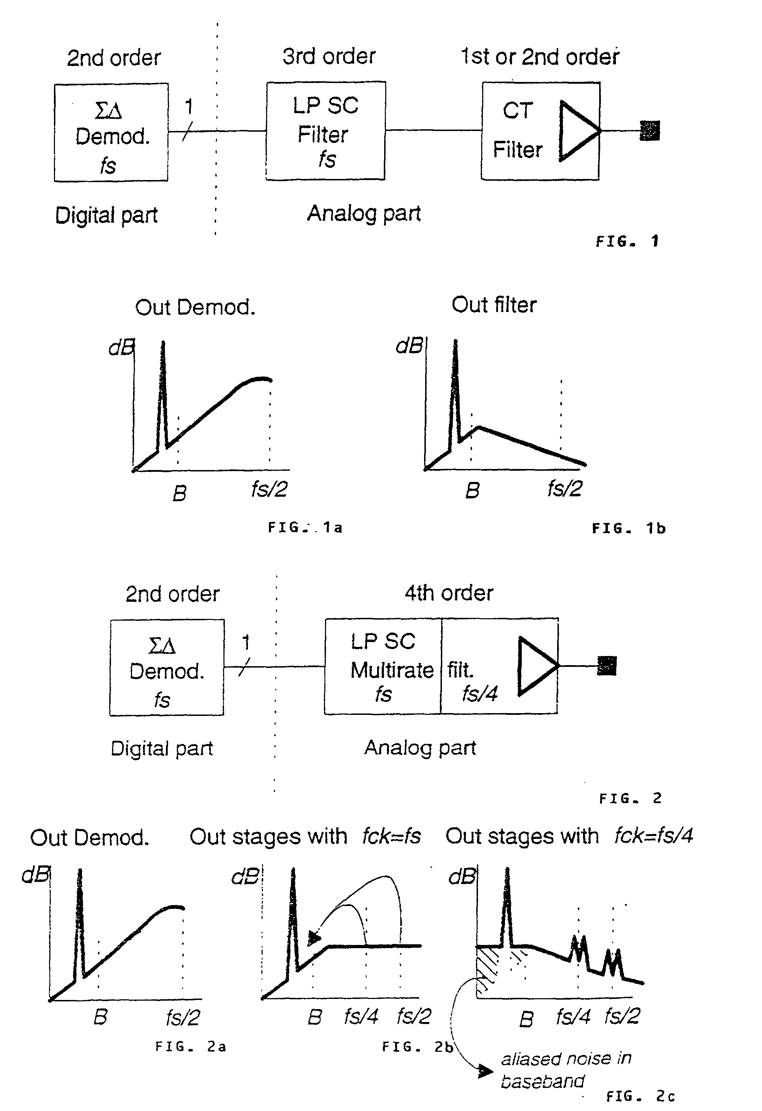

The typical approach used for implementing the low pass filter in $\Sigma\Delta$ digital-analog converters to use a cascade of two filters. The first filter is realized with a SC technique of an order $\geq 2$ functioning with a clock frequency $f_s$ equal to the frequency of the output bitstream data of the $\Sigma\Delta$ demodulator. The second filter is usually realized with a CT technique to eliminate the "imaging" in the vicinity of the $f_s$ frequency and, if requested, to drive through the filter's last stage the "off-chip" outputs. The second filter usually occupies a large area because of the high time constants that are normally realized with integrated resistors and capacitors according to the scheme shown in Figure 1, whose spectral response diagrams are illustrated in Figures 1a and 1b.

In non-audio applications, wherein rejection of the clock frequency imaging about $f_s$ is not required, an efficient solution is to use a "multirate" fully SC filter, that is, a filter of order $\geq 3$ whose first stages operate with a clock frequency $f_{ck}$ equal to $f_s$, whereas the last stages have a fck equal to $f_s/2^n$ ($n=1,2,3,...$). In this way, the last stage of the filter may function simultaneously as an off-chip buffer without an excessive consumption (indeed, the use of an SC buffer with a dock frequency equal to $f_s$ which is usually rather high, because of the oversampled nature of the output stream of the $\Sigma\Delta$ demodulator, is prohibitive for low-power applications).

The disadvantage of this solution is that in stages with a clock frequency equal to $f_s/2^n$, the noise occurring at those frequencies is brought back into the base band (B) via aliasing.

Being the $\Sigma\Delta$ D/A input node one that receives a signal with a high noise energy at frequencies well above the baseband (B) of the signal to be processed, in the vicinity of $f_s/2^n$ there is such an energy density that aliasing of this noise in the baseband degrades the signal/noise ratio (SNR) of the reconstructing filter, nullifying the beneficial effect of the $\Sigma\Delta$ conversion, as shown in the Figures 2, 2a, 2b and 2c.

Moreover, in order to further reduce the dock frequency and thus the power of the operational amplifiers, facilitating also the functioning of the output buffer, double sampled SC structure are often used. These structures are typically realized duplicating each switched-capacitor and by inverting the associated control phases. However, this realization may introduce a further aliasing error equal to the mismatch among the input capacitances of alternate phases of the first input stage.

### OBJECTIVE AND SUMMARY OF THE INVENTION

An effective solution to the above described problem is based on the placement of zeroes at a $f_s/2^n$ frequency as well as at its multiples, before the signal reconstruction filter. In this manner the signal present at the input of the filter's first stage functioning with a clock frequency of $f_s/2^n$ has a spectrum that presents notches at the frequencies of purposely introduced zeroes, with a consequent reduction of the noise energy practically nullifying the aliasing in baseband. A possible transfer function that attains this objective, assuming the case of n=2 is the following:

$$1+z^{-1}+z^{-2}+z^{-3} = (1+z^{-1})\,(1+z^{-2})$$

This function places zeroes at the frequencies $f_s/2$ and $f_s/4$, as it will be evident to a person conversant in this field.

The different aspects and characteristics of the invention among which is the provision of a circuit that efficiently implements the above discussed transfer function, are defined in the annexed claims.

The features of the invention will be evidenced in the following description of preferred embodiments, also by referring to the attached drawings.

### BRIEF DESCRIPTION OF THE DRAWINGS

**Figures 1, 1a** and **1b** show a typical block diagram of a $\Sigma\Delta$ D/A converter and the respective response spectra at the output of the $\Sigma\Delta$ demodulation stage and at the output of the signal reconstructing low pass filter.

**Figures 2, 2a, 2b** and **2c** are respectively a block diagram of a $\Sigma\Delta$ D/A converter using a multirate reconstruction low pass filter of the 4th order and the respective response spectra.

**Figures 3, 3a, 3b** and **3c** show the block diagram and the spectral response diagrams of a $\Sigma\Delta$ D/A converter using a signal reconstruction multirate filter of the 4th order, according to the present invention.

**Figures 4a** and **4b** show respectively the circuit diagram of the input stage of the filter according to a conventional known embodiment and according to an embodiment of the present invention.

**Figure 5** shows the circuit scheme of a particularly preferred embodiment of the first stage of the signal reconstruction low pass filter.

**Figure 6, 6a** and **6b** are respectively a block diagram and the simulated response spectra relative to an embodiment of the invention.

DESCRIPTION OF THE CIRCUIT OF THE INVENTION

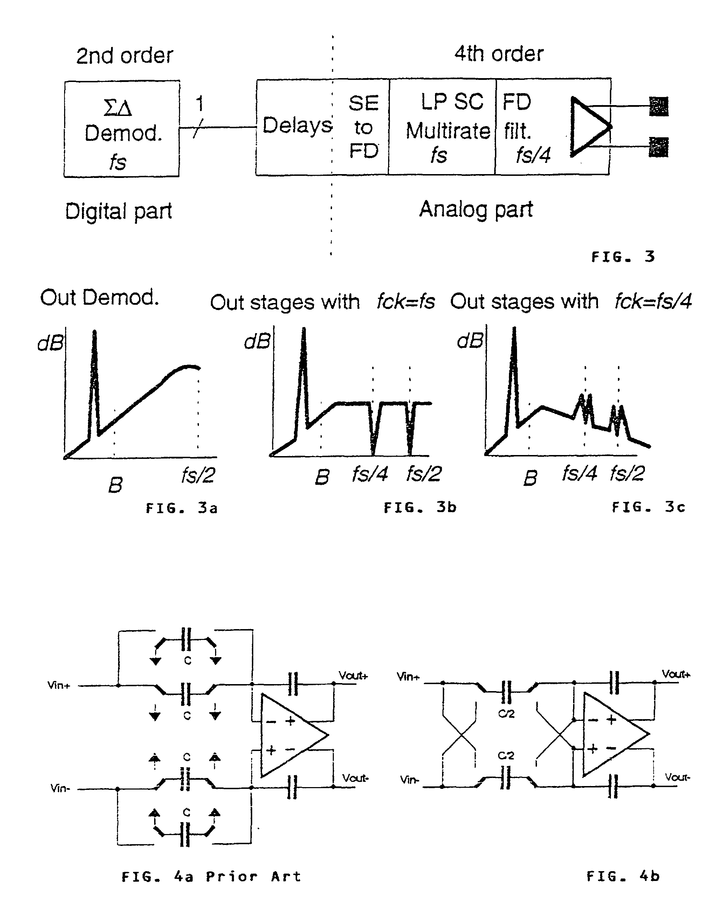

Figure 3 shows the modification introduced in an input stage of a signal reconstruction low pass filter, according to the invention.

The circuit diagram highlights the presence of a stage of delay and conversion of the signal from a single-ended (SE) configuration to a fully differential (FD) configuration and the in figures 3a, 3b and 3c are evidenced the respective diagrams of spectral response after the introduction of zeros at $f_s/2^n$ frequencies, according to the objectives of the invention.

As highlighted in Figure 4b, the fully differential input stage to the multirate signal reconstruction filter is structured in a way to realize a double sampling <u>without duplicating</u> the input capacitors of this first stage, which by contrast is the case in a classical form of realization shown, by way of comparison, in Figure 4a.

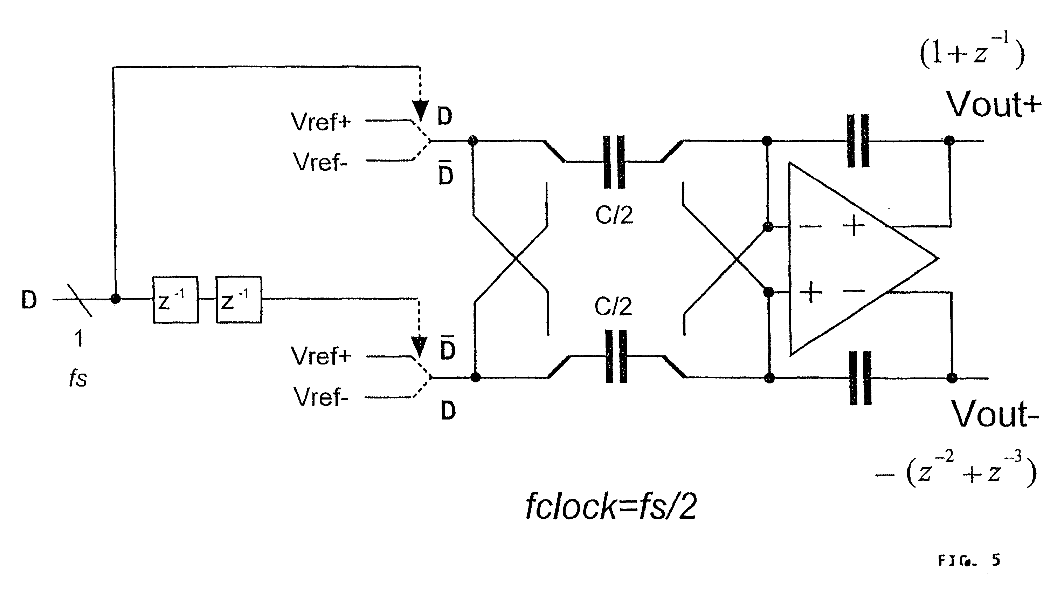

As more fully illustrated in the circuit diagram of Figure 5, the first stage of the filter uses two delay blocks ($z^{-1}$) of the digital output stream D of the $\Sigma\Delta$ demodulator of the digital/analog converter for introducing zeroes at $f_s/2^n$ frequencies.

Therefore, the fully differential, double sampled, input structure of the SC signal reconstruction filter of the invention performs double sampling without duplicating the input capacitors of the first stage of the filter, using the capacitors alternately on two inputs of the FD structure and advantageously eliminating the aliasing phenomenon caused by the mismatch among capacitors.

Simultaneously, such an input structure also realizes a SC bilinear transformation that automatically introduces a first notch at $f_s/2$. This because of the expression at the numerator of the transfer function of the structure of the invention:

$$1+z^{-1} \Rightarrow \text{notch at } f_s/2$$

At this point, in order to introduce a second notch at $f_s/4$, it is simply required to add two delaying blocks $z^{-1}$ on one of the two inputs of the fully differential structure, thus implementing an expression at numerator of the transfer function given by:

$$\frac{V_o^+ - V_o^-}{V_{in}} = \frac{N(z)P(z)}{D(z)} = \frac{1+z^{-1}+z^{-2}+z^{-3}}{D(z)} \cdot P(z)$$

where P(z)/D(z) is the transfer function associated to the first stage of the filter.

The "in band" specifications of the multirate filter remain always assured by the necessary and sufficient condition for the synthesis of a SC filter, which notably is:

$$f_s/2^n >> B$$

where B is the useful band of the signals to be processed.

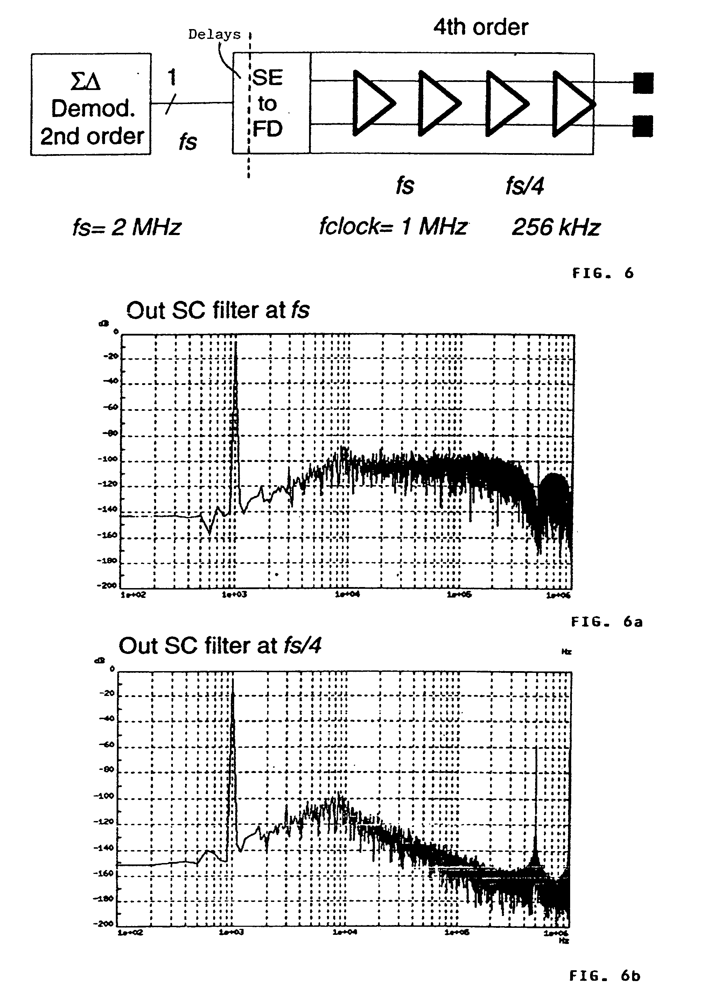

The diagram of a $\Sigma\Delta$ D/A converter realized according to the present invention is depicted in figures 6, 6a and 6b illustrate the simulations for the converter of the invention fed with a bitstream with a frequency $f_s$=2MHz having an SNR=96dB for a signal band B=4kHz ($2^{nd}$ order $\Sigma\Delta$).

In the illustrated example the reconstructing filter is a double sampled, ladder type, SC low pass filter of the $4^{th}$ order with the first two stages functioning with $f_{ck}$=1MHz and the following two stages functioning with $f_{ck}$=256kHz.

The simulations demonstrate an unchanged SNR at the output of the filter even in presence of a 1% mismatch between the input capacitors.

**Claims**

1. A sigma-delta ($\Sigma\Delta$) digital-analog converter comprising a multirate low, pass filter for reconstructing the analog signal from the output bitstream (D) of the sigma-delta demodulation stage of the converter, the input stage of said filter being a switched capacitor, fully differential, double sampled structure, **characterized in that**

   said fully differential input stage uses only two switched capacitors and has means inverting the connection of the terminals of said two capacitors to the two inputs respectively of the first or input stage of the low pass filter; and comprises further

   two delay blocks ($z^{-1}$) on the feed line of said bitstream towards one of said two inputs.

2. The converter of claim 1, wherein said delay blocks introduce zeroes in the transfer function of the multirate low pass filter at the frequencies $f_s/2^n$ where n is an integer number whose value is within the range 1 to $n_{max}$, being $f_s/2^{max}$ the clock frequency of the last stages of said multirate switched capac-

itor filter.

loge des derniers étages dudit filtre à condensateur commuté à vitesses multiples.

## Patentansprüche

1.  Sigma-delta ($\Sigma\Delta$) digital-analog Umwandler, umfassend einen Mehrgeschwindigkeit-tiefpassfilter zum Wiederherstellen des analogen Signals vom Ausgangsbitstrom (D) der sigma-delta Demodulationsstufe des Umwandlers, wobei die Ausgabestufe des genannten Filters eine ganz differentiale doppelt abgetastete Anordnung mit umgeschalteten Kondensator ist, **dadurch gekennzeichnet dass** die genannte ganz differentiale Eingabestufe nur zwei geschaltete Kondensatore verwendet und Mittel aufweist, die die Verbindung der Anschlüsse der genannten zwei Kondensatore mit den zwei Eingängen der ersten bzw. Eingabe-Stufe des Tiefpassfilters austauscht; und weiterhin zwei Verzögerungsblöcke ($z^{-1}$) auf der Versorgungsleitung für den genannten Bitstrom zu einem der zwei genannten Eingaben umfasst.

2.  Umwandler nach Anspruch 1, wobei die genannte Verzögerungsblöcke Nullwerte in der Transferfunktion des Mehrgeschwindigkeits-Tiefpassfilters mit Frequenzen $f_s/2^n$, wobei n ein ganzzähliger Nummer ist, dessen Wert zwischen 1 und $n_{max}$ beträgt, wobei $f_s/2^{max}$ die Synchronisationsuhrfrequenz der letzten Stufen des genannten Mehrgeschwindigkeitsfilters mit umgeschalteten Kondensator ist.

## Revendications

1.  Convertisseur sigma-delta ($\Sigma\Delta$) numerique-analogique, comprenant un filtre passe-bas à vitesses multiples pour reconstruire le signal analogique depuis le courant de bits en sortie (D) de l'étage de démodulation sigma-delta du convertisseur, étage d'entrée dudit filtre étant un condensateur commuté, complètement différentiel, à double structure échantillonnée, **caractérisée en ce que** ledit étage d'entrée complètement différentiel utilise seulement deux condensateurs commutés et présente des moyens qui invertissent la connexion des bornes desdits deux condensateurs, respectivement, du premier étage, ou étage d'entrée, du filtre passe-bas, et comprend en plus deux blocs de délai ($z^{-1}$) sur la ligne d'alimentation desdites deux entrées.

2.  Le convertisseur de la revendication 1, dans lequel lesdits blocs de délai introduisent des zéros dans la fonction de transfert du filtre passe-bas à vitesses multiples aux fréquences $f_s/2^n$, où n est un numéro entier, la valeur duquel est comprise dans l'intervalle de 1 à $U_{max}$, $f_s/2^{max}$ étant la fréquence de l'hor-

FIG. 1

FIG. 1a

FIG. 1b

FIG. 2

FIG. 2a

FIG. 2b

*aliased noise in baseband*

FIG. 2c

## 2nd order

## 4th order

| ΣΔ Demod. *fs* | 1 / | Delays | SE to FD | LP SC Multirate *fs* | FD filt. *fs/4* | ▷ |

Digital part

Analog part

**FIG. 3**

Out Demod.

Out stages with *fck=fs*

Out stages with *fck=fs/4*

*dB*

*B*        *fs/2*

*dB*

*B*   *fs/4*   *fs/2*

*dB*

*B*   *fs/4*   *fs/2*

**FIG. 3a**

**FIG. 3b**

**FIG. 3c**

Vin+
Vout+

C
C
C
C

Vin-
Vout-

Vin+
Vout+

C2
C2

Vin-
Vout-

**FIG. 4a Prior Art**

**FIG. 4b**

FIG. 5

EP 0 903 862 B1

FIG. 6

FIG. 6a

FIG. 6b